# EUROPÄISCHE PATENTANMELDUNG

(11) **EP 4 739 013 A1**
(43) Veröffentlichungstag der Anmeldung: **06.05.2026**
(21) Anmeldenummer: 24210629.2
(22) Anmeldetag: 04.11.2024
(51) Int. Cl.: H05K 7/14

(54) **BEFESTIGUNGSVORRICHTUNG ZUR BEFESTIGUNG EINER ELEKTRONISCHEN KOMPONENTE**

(71) Anmelder: Patchbox GmbH, 1200 Wien (AT)
(72) Erfinder: GENG, Alexander, 1090 Wien (AT)
(74) Vertreter: SONN Patentanwälte GmbH & Co KG

(57) **Zusammenfassung**

Bei einer Befestigungsvorrichtung zur Befestigung einer elektronischen Komponente (13), die wenigstens eine Befestigungslasche (14) mit wenigstens einem Loch (15) aufweist, an einem eine Lochreihe (10) aufweisenden Blechwinkel (12) eines Gestells, umfassend eine Platte (1) mit Abstützmitteln (5) zur Abstützung der Komponente (13) und einem sich in einem in Wesentlichen rechten Winkel von der Platte (1) erstreckenden Befestigungsabschnitt (2) zur Befestigung der Befestigungsvorrichtung am Blechwinkel (12), weist der Befestigungsabschnitt (2) wenigstens ein Innengewinde für das Einschrauben eines Befestigungsbolzens (6) in einer sich im Wesentlichen parallel zur Platte (1) erstreckenden Richtung auf.

## Beschreibung

Die Erfindung betrifft eine Befestigungsvorrichtung zur Befestigung einer elektronischen Komponente, die wenigstens eine Befestigungslasche mit wenigstens einem Loch aufweist, an einem eine Lochreihe aufweisenden Blechwinkel eines Gestells.

Die Erfindung betrifft weiters ein Gestell zur Aufbewahrung von elektronischen Komponenten, umfassend wenigstens zwei in Abstand voneinander angeordnete, senkrecht verlaufende und eine Lochreihe aufweisende Blechwinkel, deren zueinander weisende erste Schenkel eine Öffnung begrenzen und an denen wenigstens eine elektronische Komponente befestigt ist, wobei am ersten Schenkel jeweils eine erfindungsgemäße Befestigungsvorrichtung befestigt ist.

Unter dem Begriff Gestell ist im Zusammenhang mit der vorliegenden Erfindung und entsprechend dem fachlichen Sprachgebrauch ein Rack für elektronische Komponenten mit einer genormten Breite von z.B. 19 Zoll zu verstehen, bei dem die einzelnen Komponenten, die sich im Gestell montieren lassen, eine der genormten Breite entsprechende Breite von z.B. 19 Zoll aufweisen. In Höhenrichtung ist ein derartiges Rack üblicherweise in genormte Höheneinheiten unterteilt, wodurch wiederum die Mindesthöhe einer zu montierenden Komponente festlegt wird. Die im Gestell zu befestigenden elektronischen Komponenten haben demgemäß zumeist eine standardisierte Höhe von einer Höheneinheit oder einem Vielfachen davon. Eine Höheneinheit (HE) eines Standard 19 Zoll Gestells besitzt eine Höhe von 1,75 Zoll.

Die mit der Befestigungsvorrichtung zu befestigenden elektronischen Komponenten weisen seitlich vorstehende plattenförmige Befestigungslaschen auf, mittels welcher eine Befestigung an den Lochreihen an der Vorderseite des Gestells verlaufender Blechwinkel erfolgt. Die plattenförmigen Befestigungslaschen der elektronischen Komponente sind in ihren seitlich vorstehenden Bereichen mit Löchern versehen, die in einer mit der Lochreihe der Blechwinkel fluchtenden Position der Aufnahme von Verbindungsmitteln, insbesondere Schraubbolzen dienen. Die Blechwinkel können etwa 2 mm stark sein und sind im Falle genormter 19 Zoll Gestelle je 15,88 mm breit und bilden zwischen sich eine etwa 19 Zoll breite Öffnung aus. Die Ausführung solcher Racks ist in den folgenden Normen festgelegt: EIA 310-D, IEC 60297 und DIN 41494 SC48D. Je Höheneinheit (1,75") liegen drei Löcher in zwei Abständen von 15,88 mm (0,625") übereinander; der Abstand zum ersten Loch der nächsten Höheneinheit ist mit 12,70 mm (≙0,5") etwas geringer. So ergibt sich eine sichtbar rhythmische Wiederholung der Lochabstände.

Die Montage von elektronischen Komponenten in Gestellen ist aufwendig und gestaltet sich meist schwierig, da die elektronischen Komponenten ein gewisses Gewicht sowie eine gewisse Sperrigkeit aufweisen.

Die Montage von elektronischen Komponenten erfolgt meist an der Vorderseite des Gestells, also dort, wo die mit der Lochreihe versehenen senkrecht verlaufenden Blechwinkel angeordnet sind.

Die Löcher der Lochreihe können bei sog. "Round-hole Racks" als runde Löcher oder bei sog. "Square-hole Racks" als quadratische Löcher ausgebildet sein und sind bei sog. "Threaded-hole Racks" mit Gewinden versehen.

Da Gestelle der herkömmlichen Art keine Auflagefläche zum Aufsetzen der elektronischen Komponenten bieten, muss der Monteur die elektronische Komponente händisch in eine Position bringen, in der die Löcher an den seitlich vorstehenden Bereichen der plattenförmigen Befestigungslaschen mit den Löchern der Lochreihe der Blechwinkel fluchten, die Komponente in dieser Position halten und die Verbindungsschrauben anbringen, um die Komponente im Gestell zu fixieren. Dabei muss der Monteur die elektronische Komponente entweder selbst in der korrekten Position halten, sodass zur Befestigung der Komponente nur eine freie Hand zur Verfügung steht, oder die Montage muss zu zweit durchgeführt werden, wobei einer der Beteiligten die Komponente in der korrekten Montageposition hält und der andere die Montage vornimmt.

Auf Grund der oben genannten Unzulänglichkeiten gestaltet sich die Montage von elektronischen Komponenten in Gestellen zeitlich aufwändig und ist mit einem hohen personellen Aufwand verbunden.

Eine Verbesserung wurde durch eine Befestigungsvorrichtung gemäß der WO 2024/141836 A1 erreicht. Die Befestigungsvorrichtung weist eine Platte mit einem abgewinkelten Befestigungsabschnitt auf, der mittels unlösbar angebrachter, die Befestigungslasche der elektronischen Komponente und die Lochreihe des Gestells durchsetzender, Befestigungsbolzen am Gestell befestigt wird. Hierbei können die Befestigungsvorrichtungen vorab am jeweiligen Blechwinkel befestigt oder darin eingehängt werden und die elektronische Komponente danach an den Befestigungsvorrichtungen abgestützt werden, wofür diese mit Abstützmitteln versehen wird. Dadurch ist für die nachfolgende Montage von Schrauben oder dgl. bereits eine abgestützte Position der Komponente gewährleistet.

Die in der WO 2024/141836 A1 beschriebene Befestigungsvorrichtung ist in erster Linie für Gestelle mit gewindelosen Löchern, d.h. für "Round-hole Racks" und "Squarehole Racks" geeignet, da hier die Gewindebolzen durch die Löcher gesteckt werden können. Für die Verwendung bei "Threaded-hole Racks" ist dies nicht möglich und erfolgt stattdessen mit Hilfe von gesonderten Schrauben, was die Handhabbarkeit erschwert, den Zeitaufwand erhöht und das Mitführen gesonderter Schrauben erfordert.

Die vorliegende Erfindung zielt daher darauf ab, eine Befestigungsvorrichtung dahingehend weiterzubilden, dass mit einer einheitlichen Ausführung eine Verwendung sowohl für Gestelle mit gewindelosen Löchern als auch für Gestelle mit Gewindelöchern ermöglicht wird.

Zur Lösung dieser Aufgabe sieht die Erfindung eine Befestigungsvorrichtung zur Befestigung einer elektronischen Komponente, die wenigstens eine Befestigungslasche mit wenigstens einem Loch aufweist, an einem eine Lochreihe aufweisenden Blechwinkel eines Gestells vor, umfassend eine Platte mit Abstützmitteln zur Abstützung der Komponente und einem sich in einem im Wesentlichen rechten Winkel von der Platte erstreckenden Befestigungsabschnitt zur Befestigung der Befestigungsvorrichtung am Blechwinkel, wobei die Befestigungsvorrichtung dadurch gekennzeichnet ist, dass der Befestigungsabschnitt wenigstens ein Innengewinde für das Einschrauben eines Befestigungsbolzens in einer sich im Wesentlichen parallel zur Platte erstreckenden Richtung aufweist.

Dadurch, dass der Gewindebolzen nicht fest und unlösbar mit dem Befestigungsabschnitt verbunden ist, sondern der Befestigungsabschnitt ein Innengewinde für die lösbare Aufnahme des Befestigungsbolzens aufweist, kann zwischen einer Ausführung für Gestelle mit gewindelosen Löchern und einer Ausführung für Gestelle mit Gewindelöchern gewechselt werden. In der Ausführung für Gestelle mit gewindelosen Löchern wird der wenigstens eine Befestigungsbolzen vor der Montage in das Innengewinde geschraubt und damit eine Ausführung mit vormontiertem Befestigungsbolzen wie in der WO 2024/141836 A1 erreicht. In der Ausführung für Gestelle mit Gewindelöchern ist der wenigstens eine Gewindebolzen zunächst vom Befestigungsabschnitt getrennt. Die Befestigungsvorrichtung wird mit ihrem Befestigungsabschnitt von hinten an den Blechwinkel des Gestells gehalten und von vorne mit Hilfe des Befestigungsbolzens befestigt, indem der Befestigungsbolzen in das Gewindeloch des Blechwinkels und das damit fluchtende Innengewinde des Befestigungsabschnitts eingeschraubt wird.

In einer bevorzugten Ausführungsform ist vorgesehen, dass das Innengewinde in einer mit dem Befestigungsabschnitt vorzugsweise durch Einpressen verbundenen Hülse ausgebildet ist, wobei die Hülse an der der Platte zugewandten Seite von dem Befestigungsabschnitt vorragt.

Der Befestigungsabschnitt ist vorzugsweise einstückig mit der Platte ausgebildet und wird insbesondere durch Umbiegen eines Endabschnitts der Platte entlang einer Biegelinie geschaffen.

Da die Lochreihe des Gestells senkrecht verläuft, ist bevorzugt vorgesehen, dass der Befestigungsabschnitt der Befestigungsvorrichtung in einem rechten Winkel zur Platte verläuft. So wird erreicht, dass der Befestigungsabschnitt plan an der Lochreihe des Gestells aufliegt.

Die erfindungsgemäße Befestigungsvorrichtung ist bevorzugt dahingehend weitergebildet, dass der Befestigungsabschnitt zwei jeweils sich für das Einschrauben eines Befestigungsbolzens in einer sich im Wesentlichen parallel zur Platte erstreckenden Richtung eignende Innengewinde aufweist. Das Vorsehen zweier Bolzen ermöglicht im Vergleich zu einer Ausführungsform mit lediglich einem Bolzen eine stabilere Fixierung der elektronischen Komponente am Gestell, da die beiden Bolzen des Befestigungsabschnitts in zwei Löcher - anstatt nur in ein Loch - der Lochreihe des Gestells eingreifen. Die elektronische Komponente hält bereits ohne Verschraubung durch einhängen in die Befestigungsbolzen: Das Eigengewicht der elektronischen Komponente übt hierbei ein Kippmoment auf die Befestigungsbolzen aus, was bei geeigneter Auslegung zu einem Verkeilen der Befestigungsbolzen in den Löchern der Lochreihe des Gestells führt, sodass die elektronische Komponente auch ohne weitere Verbindungselemente am Gestell gegen ein Herabfallen gesichert ist.

Vorzugsweise weist der wenigstens eine Befestigungsbolzen einen in das Innengewinde einschraubbaren, mit einem Außengewinde versehenen ersten Bolzenabschnitt und einen mit einem Außengewinde versehenen zweiten Bolzenabschnitt auf, der im in das Innengewinde des Befestigungsabschnitts eingeschraubten Zustand des ersten Bolzenabschnitts an der der Platte abgewandten Seite vom Befestigungsabschnitt vorragt. Der zweite Bolzenabschnitt ist dabei vorgesehen, um ein Loch der Befestigungslasche der elektronischen Komponente zu durchsetzen und weist ein Außengewinde auf, um das Aufschrauben einer Schraubenmutter zu erlauben, mit welcher die Befestigungslasche gegen den Blechwinkel des Gestells gedrückt wird.

Das Außengewinde des ersten Bolzenabschnitts ist vorzugsweise an den kleinsten zu erwartenden Durchmesser bzw. das kleinste zu erwartende Innengewinde eines Gewindelochs des Blechwinkels eines "Threaded-hole Racks" angepasst, um eine universelle Verwendbarkeit für unterschiedlichste Ausführungen bzw. Dimensionierungen von Gestellen zu ermöglichen, und weist daher einen relativ geringen Durchmesser auf. Bevorzugt ist hierbei vorgesehen, dass das kleinere Gewinde erst nach einer Länge beginnt, die der maximalen Stärke des Blechwinkels entspricht, um einem Verkeilen der Gewinde der Schraube mit dem Innengewinde des Gestelles bei einer leicht unzentrierten Montage vorzubeugen. Der zweite Bolzenabschnitt hingegen ist im Hinblick auf eine ausreichende Stabilität des Befestigungssystems dimensioniert und weist vorzugsweise einen größeren Durchmesser auf als der erste Bolzenabschnitt. Die am Übergang des ersten Bolzenabschnitts zum zweiten Bolzenabschnitt auf Grund des Durchmesserunterschieds entstehende Stufe kann als Anschlagfläche beim Einschrauben des Befestigungsbolzens an den Blechwinkel (bei "Threaded-hole Racks") oder den Befestigungsabschnitt (bei "Round-hole Racks" und "Square-hole Racks") dienen.

Alternativ kann der Befestigungsbolzen zwischen dem ersten und dem zweiten Bolzenabschnitt eine über den Durchmesser des zweiten Bolzenabschnitts hinausgehende Verdickung aufweisen, die vorzugsweise profiliert, z.B. als Sechskant, ausgebildet ist. Dadurch wird die genannte Anschlagfläche vergrößert und im Fall einer profilierten Ausführung kann ein Werkzeug angesetzt werden, mit dem der Befestigungsbolzen ein- oder abgeschraubt werden kann. Diese Verdickung ist entweder vom Durchmesser so klein, dass sie innerhalb eines Vierkantlochs Platz findet oder so groß, dass sie über das Vierkantloch ragt, jedenfalls aber maximal so groß ist, dass sie nicht in die nächste Höheneinheit hineinragt.

Um eine ebene Anlagefläche des Befestigungsabschnitts an der Rückseite des Blechwinkels bereitzustellen, ist bevorzugt vorgesehen, dass an der der Platte abgewandten Seite des Befestigungsabschnitts eine Frontplatte angebracht, insbesondere angeschweißt, angeklippst, angeklebt oder gefalzt, ist, die wenigstens ein mit dem jeweiligen Innengewinde fluchtendes Durchgangsloch aufweist. Die Frontplatte ist hierbei dazu vorgesehen, etwaige Verwölbungen des Befestigungsabschnitts abzudecken, die sich beim Verpressen des Innengewindes ergeben.

Um ein sicheres Abstützen der elektronischen Komponente an den Befestigungsvorrichtungen zu erreichen, weist die Platte Abstützmittel auf, die so ausgebildet sind, dass die elektronische Komponente gegen die Schwerkraft abstützbar ist. Dies erfolgt in einfacher Weise zum Beispiel durch ein Formschlusselement, welches mit der Komponente in formschlüssigen Eingriff bringbar ist.

In vorteilhafter Weise ist die erfindungsgemäße Befestigungsvorrichtung dahingehend weitergebildet, dass die Platte mit einer langen und einer kurzen Seite, insbesondere rechteckig, ausgebildet ist, wobei der Befestigungsabschnitt an der kurzen Seite umgebogen ist und an der langen Seite ein das Formschlusselement ausbildender Halteabschnitt umgebogen ist, auf dem die Komponente abstützbar ist, wobei vorzugsweise der Halteabschnitt ausgehend von der Plattenebene in eine dem Befestigungsabschnitt entgegengesetzte Richtung umgebogen ist. Entsprechend dieser bevorzugten Ausführungsform liegen die Seitenbereiche der elektronischen Komponente mit ihrer Unterseite formschlüssig auf dem jeweiligen Halteabschnitt auf, wodurch eine stabile Abstützung der Komponente innerhalb des Gestells ermöglicht und die Montage der Komponente signifikant erleichtert wird.

Ein weiterer Vorteil dieser Ausführungsform liegt darin, dass elektronische Komponenten, die keine gesonderte Vorrichtung für eine Montage an den vorderen und ggf. hinteren Blechwinkeln des Gestells aufweisen, wie z.B. ein Server mit lediglich seitlich befestigten Serverschienen, platzsparend befestigt werden können.

Gemäß einer alternativen Ausbildung ist bevorzugt vorgesehen, dass das Formschlusselement von einem hakenartig umgebogenen Endbereich der Platte gebildet ist. Der hakenartig umgebogene Endbereich kann beispielsweise in einen korrespondierenden Schlitz der elektronischen Komponente eingeführt werden und dort für einen Formschluss gegen die Schwerkraft sorgen.

Die Erfindung betrifft weiters ein Gestell zur Aufbewahrung von elektronischen Komponenten, umfassend wenigstens zwei in Abstand voneinander angeordnete, senkrecht verlaufende und eine Lochreihe aufweisende Blechwinkel, deren zueinander weisende erste Schenkel eine Öffnung begrenzen und an denen wenigstens eine elektronische Komponente befestigt ist, wobei die elektronische Komponente im Wesentlichen eine der Öffnung entsprechende Breite und wenigstens zwei an einer Vorderseite an ihren Rändern nach außen vorspringende, mit der Vorderseite vorzugsweise fluchtende Befestigungslaschen aufweist, welche an den ersten Schenkeln anliegend angeordnet sind und mit Löchern der Lochreihe fluchtende Löcher aufweisen, und wobei am ersten Schenkel jeweils eine vorstehend erläuterte Befestigungsvorrichtung befestigt ist, von welcher der wenigstens eine Befestigungsbolzen in das jeweilige Innengewinde des Befestigungsabschnitts eingeschraubt ist und die Löcher der Befestigungslasche und der Lochreihe durchsetzt, wobei die Komponente an den Befestigungsvorrichtungen insbesondere formschlüssig gegen die Schwerkraft abgestützt ist.

Dabei handelt es sich beim ersten Schenkel des jeweiligen Blechwinkels des Gestells um jenen Schenkel, an denen die Befestigungslaschen der elektronischen Komponenten befestigt werden und die in der Regel in einer gemeinsamen vorderen Ebene liegen.

Die Befestigungslaschen der Komponente liegen hierbei auf der Vorderseite, d.h. der dem Inneren des Gestells abgewandten Seite, der Lochreihe auf und können so von den mit der Befestigungsvorrichtung verbundenen, die Löcher durchsetzenden Befestigungsbolzen, gehalten werden, wodurch eine Fixierung der Komponente am Gestell erreicht wird. Bevorzugt ist hierbei vorgesehen, dass der Befestigungsabschnitt der Befestigungsvorrichtung an der Innenseite des Blechwinkels am ersten Schenkel angeordnet ist.

Im Falle der Fixierung an einem "Threaded-hole Rack" ist bevorzugt vorgesehen, dass die Löcher der Lochreihe jeweils als Gewindeloch ausgebildet sind und die Befestigungsbolzen derart in das jeweilige Innengewinde der Befestigungsvorrichtung eingeschraubt sind, dass die Verdickung des jeweiligen Befestigungsbolzens gegen den ersten Schenkel des Blechwinkels drückt, und wobei eine auf den zweiten Bolzenabschnitt aufgeschraubte Schraubenmutter die Befestigungslasche gegen den ersten Schenkel des Blechwinkels drückt.

Im Falle von "Round-hole Racks" und "Square-hole Racks" ist bevorzugt vorgesehen, dass die Löcher der Lochreihe jeweils als gewindeloses Loch, insbesondere als Vierkantloch, ausgebildet sind, wobei die Verdickung des Befestigungsbolzens im jeweiligen Vierkantloch angeordnet ist und eine auf den zweiten Bolzenabschnitt aufgeschraubte Schraubenmutter die Befestigungslasche gegen den ersten Schenkel des Blechwinkels drückt. Die Anordnung der Verdickung im jeweiligen Vierkantloch dient als Zentrierung der Befestigungsvorrichtung relativ zum Loch der Lochreihe des Blechwinkels, um eine präzise Positionierung der Befestigungsvorrichtung zu erreichen.

Das Gestell weist bevorzugt vier einen quaderförmigen Aufbewahrungsraum begrenzende Blechwinkel auf und die Befestigungsvorrichtungen bildet keine durchgehende Verbindung zwischen zwei benachbarten Blechwinkeln aus.

Jeweils zwei der vier den quaderförmigen Aufbewahrungsraum begrenzenden Blechwinkel bilden die Vorder- bzw. die Rückseite des Gestells.

Entsprechend dieser bevorzugten Ausführungsform ragt die an der Vorder- bzw. Hinterseite der Lochreihe befestigte Befestigungsvorrichtung in das Innere des quaderförmigen Aufbewahrungsraumes, d.h. erstreckt sich in Richtung eines zweiten Schenkels des Blechwinkels des Gestells. Die erfindungsgemäße Befestigungsvorrichtung ermöglicht hierbei eine stabile Befestigung einer elektronischen Komponente in einem Gestell, ohne dass - wie im Stand der Technik vorgesehen - eine Verbindung zwischen zwei benachbarten Blechwinkeln vonnöten wäre.

Die Erfindung wird nachfolgend anhand von in der Zeichnung schematisch dargestellten Ausführungsbeispielen näher erläutert. In dieser zeigen Fig. 1 eine erfindungsgemäße Befestigungsvorrichtung in einer perspektivischen Ansicht, Fig.2 die Befestigungsvorrichtung gemäß Fig. 2 in einer Draufsicht, Fig.3 eine Befestigungsschraube zur Verwendung mit einer erfindungsgemäßen Befestigungsvorrichtung, Fig. 4 die Anbringung der Befestigungsvorrichtung in Kombination mit einer elektronischen Komponente an einem Gestell mit gewindelosen Vierkantlöchern und Fig. 5 die Anbringung der Befestigungsvorrichtung in Kombination mit einer elektronischen Komponente an einem Gestell mit Gewindelöchern.

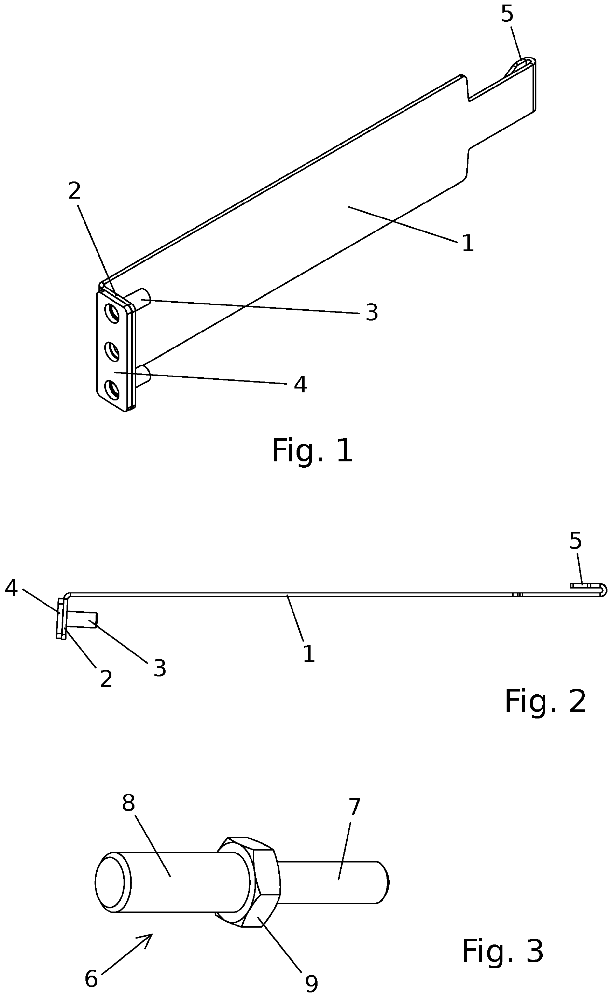

Wie in Fig. 1 und 2 dargestellt, weist die Befestigungsvorrichtung eine Platte 1 und einen entlang einer Biegelinie aus der Platte 1 umgebogenen Befestigungsabschnitt 2 auf. Der Befestigungsabschnitt 2 verläuft hierbei in einem rechten Winkel zur Platte 1. Der Befestigungsabschnitt 2 ist mit zwei Hülsen 3 mit Innengewinde versehen, die sich an der der Platte 1 zugewandten Seite des Befestigungsabschnitts 2 von diesem weg erstrecken. An der der Platte 1 abgewandten Seite des Befestigungsabschnitts 2 ist an diesem eine Frontplatte 4 angebracht. Die Platte 1 weist weiters ein in Richtung der Biegeline wirksames Formschlusselement 5 in Form eines hakenartig umgebogenen Endbereichs der Platte 1 auf, das in einen entsprechenden Schlitz der elektronischen Komponente einführbar ist (in Fig.1 und 2 nicht gezeigt), um die Komponente gegen die Schwerkraft abzustützen.

Fig. 3 zeigt einen Befestigungsbolzen 6, der in das Innengewinde der Hülse 3 eingeschraubt werden kann. Der Befestigungsbolzen weist hierzu einen ersten Bolzenabschnitt 7 mit einem Außengewinde auf, wie z.B. ein 8/32-Zoll Gewinde, das in das genannte Innengewinde einschraubbar ist. Weiters weist der Befestigungsbolzen 6 einen zweiten Bolzenabschnitt 8 auf, der ein Außengewinde mit einem gegenüber dem ersten Bolzenabschnitt 7 größeren Gewindedurchmesser aufweist, wie z.B. ein M6-Gewinde. Zwischen dem ersten bolzenabschnitt 7 und dem zweiten Bolzenabschnitt 8 ist eine Sechskant-Verdickung 9 vorgesehen, die dem Angriff eines Werkzeugs dient.

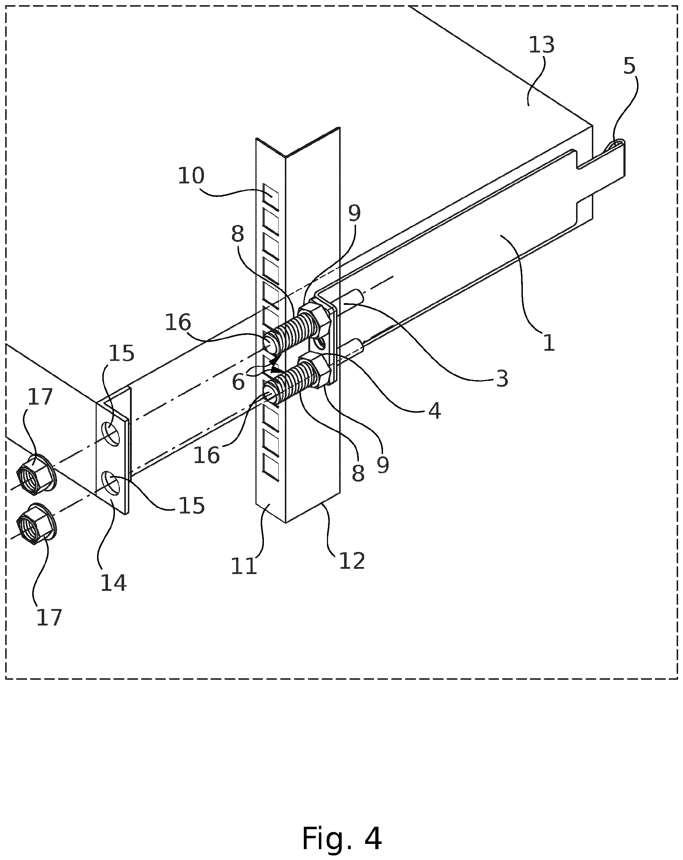

Fig. 4 zeigt die erfindungsgemäße Befestigungsvorrichtung 1 in Kombination mit einer Vierkant-Lochreihe 10 an einem ersten Schenkel 11 eines Blechwinkels 12 eines Gestells und einer am Gestell zu befestigenden elektronischen Komponente 13. Die elektronische Komponente 13 ist beiderseits mit Befestigungslaschen 14 mit jeweils zwei Löchern 15 ausgestattet, welche im montierten Zustand mit den Vierkantlöchern 16 der Lochreihe 10 fluchten.

Vor der Montage werden die Befestigungsbolzen 6 mit ihrem ersten Bolzenabschnitt 7 in das Innengewinde der Hülsen 3 fest eingeschraubt. Danach wird die Befestigungsvorrichtung von hinten an den ersten Schenkel 11 des Blechwinkels 12 gelegt, sodass die Befestigungsbolzen 6 mit ihren zweiten Bolzenabschnitten 8 die Vierkantlöcher 16 durchsetzen und die Sechskant-Verdickungen 9 innerhalb der Vierkantlöcher angeordnet sind. Dann wird die elektronische Komponente 13 mit den Befestigungslaschen 14 so eingeführt, dass die zweiten Bolzenabschnitte 8 die Löcher 15 durchsetzen und das Formschlusselement 5 in einen korrespondierenden Schlitz der Komponente 13 eingeführt wird, worauf die Befestigungslasche 14 durch Aufschrauben von Schraubenmuttern 17 festgespannt wird.

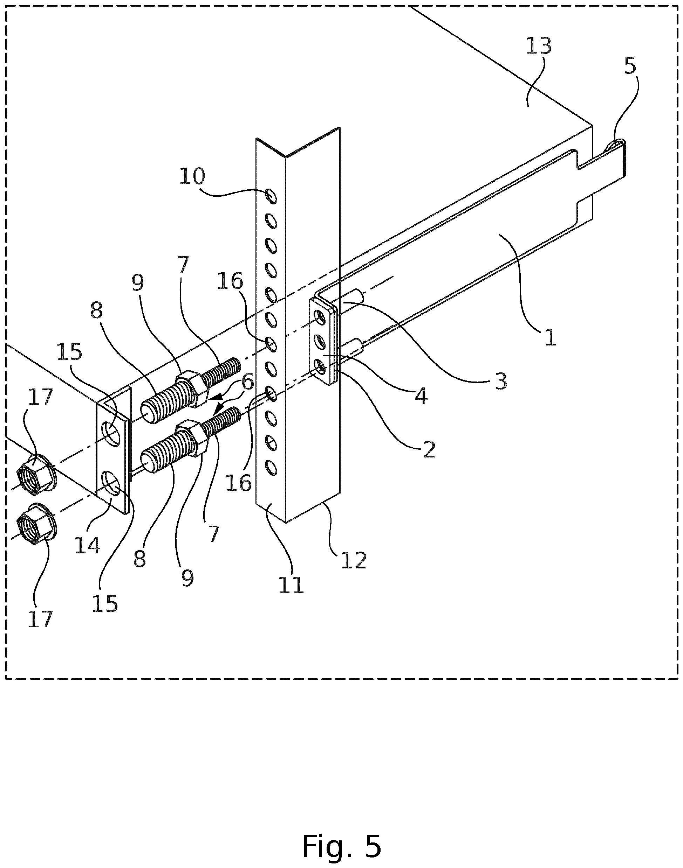

Fig. 5 zeigt die Montage der Befestigungsvorrichtung und der elektronischen Komponente 13 an einem Gestell mit Gewindelöchern 16 ("Threaded-hole Rack"). Hierzu wird die Befestigungsvorrichtung zunächst von hinten an den ersten Schenkel 11 des Blechwinkels 12 gelegt und der Befestigungsbolzen 6 von vorne in das Gewindeloch 16 und weiter in das Innengewinde der Hülse 3 eingeschraubt bis die Sechskant-Verdickung am ersten Schenkel 11 anschlägt und die Gewindeverbindung festgezogen ist. Danach wird die Komponente 13 mit der Befestigungslasche 14 von vorne so angelegt, dass die zweiten Bolzenabschnitte 8 die Löcher 15 durchsetzen, worauf die Schraubenmuttern 17 aufgeschraubt und festgezogen werden.

## Patentansprüche

1. Befestigungsvorrichtung zur Befestigung einer elektronischen Komponente (13), die wenigstens eine Befestigungslasche (14) mit wenigstens einem Loch (15) aufweist, an einem eine Lochreihe (10) aufweisenden Blechwinkel (12) eines Gestells, umfassend eine Platte (1) mit Abstützmitteln (5) zur Abstützung der Komponente (13) und einem sich in einem in Wesentlichen rechten Winkel von der Platte (1) erstreckenden Befestigungsabschnitt (2) zur Befestigung der Befestigungsvorrichtung am Blechwinkel (12), **dadurch gekennzeichnet, dass** der Befestigungsabschnitt (2) wenigstens ein Innengewinde für das Einschrauben eines Befestigungsbolzens (6) in einer sich im Wesentlichen parallel zur Platte (1) erstreckenden Richtung aufweist.

2. Befestigungsvorrichtung nach Anspruch 1, **dadurch gekennzeichnet, dass** das Innengewinde in einer mit dem Befestigungsabschnitt (2) vorzugsweise durch Einpressen verbundenen Hülse (3) ausgebildet ist.

3. Befestigungsvorrichtung nach Anspruch 1 oder 2, **dadurch gekennzeichnet, dass** der Befestigungsabschnitt (2) zwei jeweils sich für das Einschrauben eines Befestigungsbolzens (6) in einer sich im Wesentlichen parallel zur Platte (1) erstreckenden Richtung eignende Innengewinde aufweist.

4. Befestigungsvorrichtung nach Anspruch 1, 2 oder 3 **dadurch gekennzeichnet**, weiters umfassend wenigstens einen Befestigungsbolzen (6), der in das jeweilige Innengewinde einschraubbar ist.

5. Befestigungsvorrichtung nach einem der Ansprüche 1 bis 4, **dadurch gekennzeichnet, dass** der wenigstens eine Befestigungsbolzen (6) einen in das Innengewinde einschraubbaren, mit einem Außengewinde versehenen ersten Bolzenabschnitt (7) und einen mit einem Außengewinde versehenen zweiten Bolzenabschnitt (8) aufweist, der im in das Innengewinde des Befestigungsabschnitts (2) eingeschraubten Zustand des ersten Bolzenabschnitts (7) an der der Platte (1) abgewandten Seite vom Befestigungsabschnitt (2) vorragt.

6. Befestigungsvorrichtung nach Anspruch 5, **dadurch gekennzeichnet, dass** der zweite Bolzenabschnitt (8) einen größeren Durchmesser aufweist als der erste Bolzenabschnitt (7).

7. Befestigungsvorrichtung nach Anspruch 5 oder 6, **dadurch gekennzeichnet, dass** der Befestigungsbolzen (6) zwischen dem ersten Bolzenabschnitt (7) und dem zweiten Bolzenabschnitt (8) eine über den Durchmesser des zweiten Bolzenabschnitts (8) hinausgehende Verdickung (9) aufweist, die vorzugsweise profiliert, z.B. als Sechskant, ausgebildet ist.

8. Befestigungsvorrichtung nach einem der Ansprüche 1 bis 7, **dadurch gekennzeichnet, dass** der Befestigungsabschnitt (2) ein zwischen den Innengewinden angeordnetes Durchgangsloch aufweist.

9. Befestigungsvorrichtung nach einem der Ansprüche 1 bis 8, **dadurch gekennzeichnet, dass** an der der Platte (1) abgewandten Seite des Befestigungsabschnitts (2) eine Frontplatte (4) angebracht, insbesondere angeschweißt, ist, die wenigstens ein mit dem jeweiligen Innengewinde fluchtendes Durchgangsloch aufweist.

10. Befestigungsvorrichtung nach einem der Ansprüche 1 bis 9, **dadurch gekennzeichnet, dass** die Abstützmittel ein Formschlusselement (5) aufweisen, welches mit der Komponente (13) in formschlüssigen Eingriff bringbar ist, um die Komponente (13) gegen die Schwerkraft abzustützen.

11. Befestigungsvorrichtung nach Anspruch 10, **dadurch gekennzeichnet, dass** die Platte (1) mit einer langen und einer kurzen Seite, insbesondere rechteckig, ausgebildet ist, wobei der Befestigungsabschnitt (2) an der kurzen Seite angeordnet ist und an der langen Seite ein das Formschlusselement (5) ausbildender Halteabschnitt umgebogen ist, auf dem die Komponente (13) abstützbar ist, wobei vorzugsweise der Halteabschnitt ausgehend von der Plattenebene in eine dem Befestigungsabschnitt (2) entgegengesetzte Richtung umgebogen ist.

12. Befestigungsvorrichtung nach Anspruch 11, **dadurch gekennzeichnet, dass** das Formschlusselement (5) von einem hakenartig umgebogenen Endbereich der Platte (1) gebildet ist.

13. Gestell zur Aufbewahrung von elektronischen Komponenten (13), umfassend wenigstens zwei in Abstand voneinander angeordnete, senkrecht verlaufende und eine Lochreihe (10) aufweisende Blechwinkel (12), deren zueinander weisende erste Schenkel (11) eine Öffnung begrenzen und an denen wenigstens eine elektronische Komponente (13) befestigt ist, wobei die elektronische Komponente (13) im Wesentlichen eine der Öffnung entsprechende Breite und wenigstens zwei an einer Vorderseite an ihren Rändern nach außen vorspringende, mit der Vorderseite vorzugsweise fluchtende Befestigungslaschen (14) aufweist, welche an den ersten Schenkeln (11) anliegend angeordnet sind und mit Löchern (16) der Lochreihe (10) fluchtende Löcher (15) aufweisen, und wobei am ersten Schenkel (11) jeweils eine Befestigungsvorrichtung nach einem der Ansprüche 1 bis 12 befestigt ist, von welcher der wenigstens eine Befestigungsbolzen (6) in das jeweilige Innengewinde des Befestigungsabschnitts (2) eingeschraubt ist und die Löcher (15,16) der Befestigungslasche (14) und der Lochreihe (10) durchsetzt, wobei die Komponente (13) an den Befestigungsvorrichtungen insbesondere formschlüssig gegen die Schwerkraft abgestützt ist.

14. Gestell nach Anspruch 13, **dadurch gekennzeichnet, dass** der Befestigungsabschnitt (2) an der Innenseite des Blechwinkels (12) am ersten Schenkel (11) angeordnet ist.

15. Gestell nach Anspruch 13 oder 14, **dadurch gekennzeichnet, dass** die Löcher (16) der Lochreihe (10) jeweils als Gewindeloch ausgebildet sind und die Befestigungsbolzen (6) derart in das jeweilige Innengewinde der Befestigungsvorrichtung eingeschraubt sind, dass die Verdickung (9) des jeweiligen Befestigungsbolzens (6) gegen den ersten Schenkel (11) des Blechwinkels (12) drückt, und wobei eine auf den zweiten Bolzenabschnitt (8) aufgeschraubte Schraubenmutter (17) die Befestigungslasche (14) gegen den ersten Schenkel (11) des Blechwinkels (12) drückt.

16. Gestell nach Anspruch 13 oder 14, **dadurch gekennzeichnet, dass** die Löcher (16) der Lochreihe (10) jeweils als gewindeloses Loch, insbesondere als Vierkantloch, ausgebildet sind, wobei die Verdickung (9) des Befestigungsbolzens (6) im jeweiligen Vierkantloch (16) angeordnet ist und eine auf den zweiten Bolzenabschnitt (8) aufgeschraubte Schraubenmutter (17) die Befestigungslasche (14) gegen den ersten Schenkel (11) des Blechwinkels (12) drückt.

17. Gestell nach einem der Ansprüche 13 bis 16, **dadurch gekennzeichnet, dass** die Komponente (13) auf dem Halteabschnitt aufliegt.

18. Gestell nach einem der Ansprüche 13 bis 17, **dadurch gekennzeichnet, dass** der hakenartig umgebogene Endbereich (5) in eine schlitzförmige Ausnehmung der Komponente (13) eingreift.

19. Gestell nach einem der Ansprüche 13 bis 18, **dadurch gekennzeichnet, dass** das Gestell vier einen quaderförmigen Aufbewahrungsraum begrenzende Blechwinkel (12) aufweist und die Befestigungsvorrichtungen keine durchgehende Verbindung zwischen zwei benachbarten Blechwinkeln (12) ausbilden.
